# EUROPEAN PATENT APPLICATION

(11) **EP 1 464 731 A1**
(43) Date of publication of application: **06.10.2004**
(21) Application number: 01274958.6
(22) Date of filing: 12.12.2001
(51) Int. Cl.: C25D 7/00, C25D 7/12, C25D 17/00, C25D 17/08, C25D 19/00, H01L 23/50

(54) **PLATING APPARATUS, PLATING METHOD, AND METHOD FOR MANUFACTURING SEMICONDUCTOR DEVICE**

(71) Applicant: Sanyo Electric Co., Ltd., Moriguchi-shi, Osaka-fu 570-8677 (JP)
(72) Inventor: KAMEYAMA, Koujiro, Ota-shi, Gunma 373-0813 (JP)
(74) Representative: Riesenberg, Axel
(86) International application number: PCT/JP2001/010873
(87) International publication number: WO 2003/050328

(57) **Abstract**

Problem: It has been desired to form a plurality of combinations of plating films continuously on a single transfer rail and to form a plating film having a high quality and a uniform thickness on the surfaces of a lead frame and leads. Solving means: The plating apparatus is provided below the single transfer rail with a plurality of plating tanks, in which plating solution baths are disposed. By moving the plating solution between the plating tanks and the plating solution baths, it is possible to select a plating film to be formed on a conductive member (21). As a result, it is possible to form combinations of plating films on the conductive member (21) continuously by the single transfer rail.

## Description

### Technical Field of the Invention

The present invention relates to a plating apparatus, a plating method and a manufacturing method for a semiconductor device wherein at least two plating film layers are formed on leads and a lead frame having a main material of Cu or an Fe-Ni alloy.

### Prior Art

A lead member wherein the surface of a conductive material made of, for example, simple Cu, a Cu alloy or an Fe-Ni alloy, is covered with a plating layer made of, for example, simple Sn or an Sn alloy, has excellent conductance and mechanical strength provided by simple Cu or a Cu alloy. In addition, such a lead member is a high performance conductor that has both resistance to corrosion as well as excellent solderability provided by simple Sn or an Sn alloy. Therefore, such members are widely used in the field of electrical and electronic apparatuses, such as in a variety of terminals, connectors and leads as well as in the field of power cables.

In addition, in the case that a semiconductor chip is mounted on a circuit substrate, hot-dip plating or electrical plating is carried out on outer lead parts of the semiconductor chip using an Sn alloy and, thereby, solderability of the outer lead parts is increased. A representative example of such an Sn alloy is solder (Sn-Pb alloy) which has excellent solderability and resistance to corrosion and, therefore, is widely utilized in industrial plating of electrical and electronic industrial members such as connectors and lead frames.

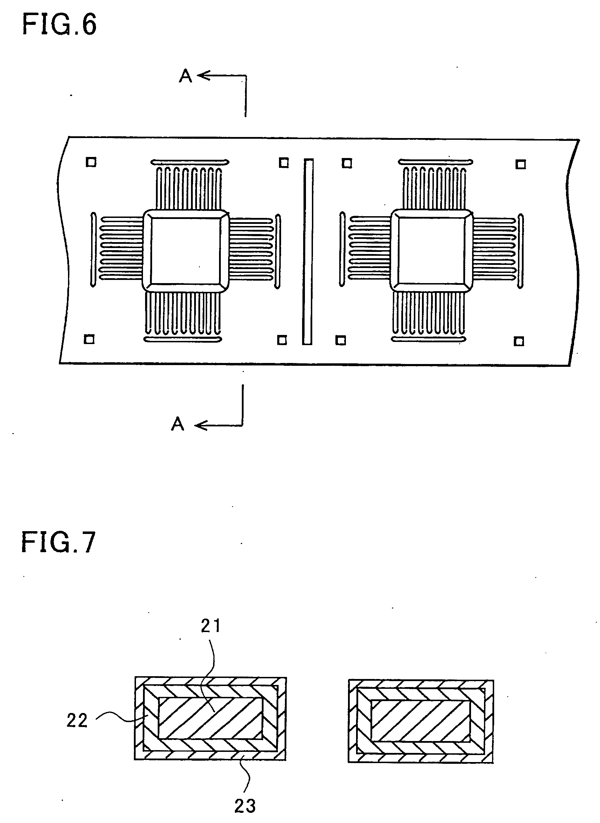

Fig. 7 is a cross sectional view showing the basic configuration of a lead member, being the A-A cross section of the semiconductor lead frame shown in Fig. 6. A conductive material 21 is formed of, for example, Cu, a Cu-based alloy having Cu as a primary component or an Fe-Ni-based alloy having Fe-Ni as a primary component. Then, two plating film layers made of differing metal materials are placed on the surface of such a conductive material 21. A first plating film 22 made of Sn and a second plating film 23 made of Sn-Bi, for example, are formed, in this order. Here, it is known that when the thickness of first plating film 22 is denoted as t₁ and the thickness of second plating film 3 is denoted as t₂, it is preferable for t₁ to be set at approximately 3 µm to 15 µm, for t₂ to be set at approximately 1 µm to 5 µm and for t₂/t₁ to be set at approximately 0.1 to 0.5 because performance in the lead member can be improved from the point of view of cost, solderability and resistance to heat, and there are excellent properties concerning junction strength with solder as well as welding strength of the welded portion with an aluminum wire, or the like.

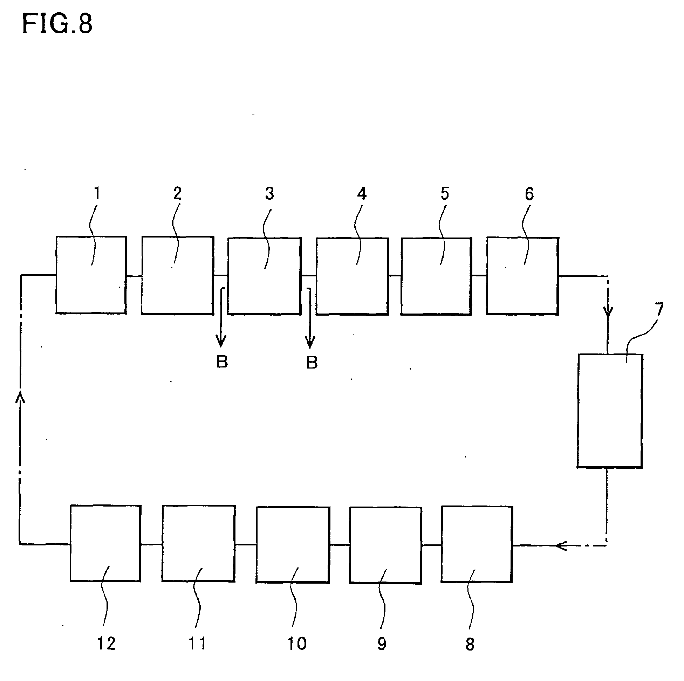

Fig. 8 is a layout of the entirety of an automatic plating apparatus. First, an organic pollutant, such as fats and oils, that hinders the adhesion and solderability of solder plating film on the surface of conductive material 21 is removed in an alkaline electrolytic washing bath 1. Next, the conductive material is washed in a water washing bath 2 and, after that, a chemical etching process (essentially a process utilizing an oxidation-reduction reaction) is carried out in a chemical etching bath 3 so that the surface of conductive material 21, which has become uneven due to the existence of grain interfaces, inclusion, or the like, is made uniform.

Next, the conductive material is washed in a water washing bath 4 and, after that, an oxide film that has become attached to the conductive material in water washing bath 4 is removed in an acid activation bath 5. Next, the conductive material is washed in a water washing bath 6 and, after that, plating is carried out in a solder plating apparatus 7. Since the solder plating liquid is strongly acidic, the surface after plating becomes acidic. The color of the film changes on such a surface as time elapses and the solderability deteriorates. Therefore, the acid that remains on the plating surface is neutralized and the attached organic substance is removed in a water washing bath 8 and in a neutralization process bath 9. After that, the conductive material is washed in a water washing bath 10 and in a hot water washing bath 11 and the plated conductive material 21 is dried in a drying apparatus 12.

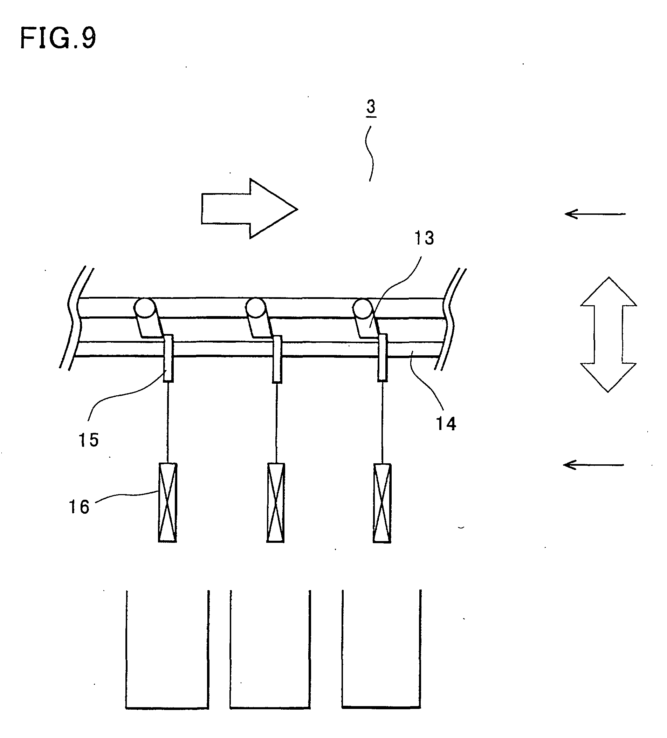

Fig. 9 is a cross sectional view in the B-B direction of chemical etching bath 3 of the plating apparatus of which the entirety is shown in Fig. 8.

The reaction in this chemical etching bath 3 is as described above. Here, the mechanism of this plating apparatus is described. Lateral transfer-type pushers 13 and a conveyance rail 14 are both moveable in the upward and downward directions in this plating apparatus. Then, the upper limit positions and the lower limit positions of these moveable ranges are determined so that the above repeatedly move between those limit positions. Hooks 15 for hanging are hung from conveyance rail 14 at appropriate intervals in accordance with the purpose of work. The intervals are usually set at intervals corresponding to the distance between the centers of adjacent baths. Then, auxiliary plating racks 16 for hanging conductive materials 21 to be plated are hung from these hooks 15 for hanging and are set in this plating apparatus. Next, lateral transfer-type pushers 13 are described. The distance between lateral transfer-type pushers 13 is basically the same as the distance between the centers of adjacent baths. Then, these lateral transfer-type pushers 13 are installed in single arms so that, when a hook 15 for hanging is transferred by one span in the direction of work, a pusher is returned by the same amount. Then, these lateral transfer-type pushers 13 are transferred by one span at the upper limit positions and are returned by the same amount at the lower limit positions. In addition, conveyance rail 14 moves in the upward and downward directions and does not move in the direction of progress. These actions are repeated and, thereby, this plating apparatus functions.

The above described plating apparatus has one pre-plating process line and one solder plating line. There are cases wherein, for example, a plating film of Sn is formed as first plating film 22 and a plating film of Sn-Bi is formed as second plating film 23 on conductive material 21, and wherein a plating film of Sn is formed as first plating film 22 and a plating film of Sn-Ag is formed as second plating film 23 on conductive material 21. In both cases the same Sn plating liquid can be utilized for the formation of the first plating film while different plating liquids must be utilized for the formation of the second plating film. Therefore, after formation of the first plating film on conductive material 21 is completed, the plating apparatus is once stopped and the plating liquid in the bath is switched to the plating liquid for the second plating film and, then, the plating film is formed on the next conductive material 21.

In addition, according to the above described solder plating method, the plating bath in the plating line has a plating liquid for forming a plating film on conductive material 21 and an electrode for supplying current to conductive material 21 in the plating apparatus used in this method. Here, the electrode installed within this plating bath is used primarily as an anode in electrical plating. Then, conductive material 21 is immersed in this plating bath and, at this time, conductive material 21 works as a cathode and, thereby, a plating film is formed. At this time, the plating work is carried out by placing conductive material 21 on a rectangular auxiliary plating rack 16 formed of two main pillars. There are conductive materials 21 having, for example, different package sizes, different package designs and different properties. Then, plating work is carried out by applying a strong current density to the plating liquid when a thick plating film is formed on such conductive materials 21. A plating film having a variety of thicknesses is formed primarily by adjusting the current density in such a manner.

In addition, it is known that in electrical plating, the closer to the edge the position of application of current in conductive material 21 becomes, the greater the current density becomes and the thicker the formed plating film becomes. Moreover, the upper limit of the range of current density that is appropriate for the plating liquid is referred to as the maximum current density. By utilizing this maximum current density, high speed plating can be achieved and plating time can be reduced. However, in the case that this maximum current density is exceeded, the plating surface becomes fogged and, furthermore, burn deposits or powder deposits are formed. Moreover, it is also known that when the limit current density is reached, no plating film can be formed.

### Problem to be Solved by the Invention

As for the first problem, the above described solder plating apparatus has one plating pre-processing line and one solder plating line. Therefore, in the case that a plurality of combined plating films is formed on conductive material 21, a problem arises wherein work cannot be sequentially carried out when combinations of plating films are switched. In other words, this plating apparatus allows sequential formation of plating films wherein the same plating films are combined by sequentially immersing conductive material 21 in the prepared plating liquid. However, a plurality of combined plating films cannot be sequentially formed on conductive material 21 in accordance with usage applications wherein the plated conductive material 21 is utilized. That is to say, there is a problem wherein excessive time and effort must be spent to replace the plating liquid in the solder plating line.

In addition to the above description, a great effort must be made in order to manage the solder plating line. There is a case wherein one type of plating liquid is utilized in one plating bath and, after that, another type of plating liquid having different plating liquid components is utilized. At this time the liquid components of the latter plating liquid are changed, unless the former plating liquid is completely removed. In addition, in the case that the utilized plating liquid components differ, the anodes utilized in the plating bath also differ and the anodes must be changed. That is to say, there is a problem wherein great effort must be made concerning maintenance, such as management of the plating liquid and management of the plating bath.

As for the second problem, according to the above described solder plating method, the plating bath in the plating line has a plating liquid for forming a plating film on conductive material 21 and an electrode for supplying current to conductive material 21 in the plating apparatus used in the method. Then, a plating film is formed using such a plating apparatus. However, a variety of types of conductive material 21 exist according to the size of the surface area or design. Therefore, all portions of the surface of conductive material 21, which work as a cathode, do not necessarily allow a uniform current to pass through when current flows from the anode to the cathode. In other words, the respective portions of conductive material 21 are not necessarily located at equal distances from the anode. Then, plating work is carried out by placing conductive material 21 on rectangular auxiliary plating rack 16 formed of two main pillars in this plating apparatus. Therefore, conductive material 21 has one surface to receive current density from the anode and, therefore, the closer to the edge of conductive material 21 the portion on which the current density concentrates is located, the greater the current density becomes concentrated and the thicker the plating film formed so that a thinner plating film is formed on the center portions of conductive material 21, in comparison with the edge. In addition, there is a problem wherein, when a plating film is formed on conductive material 21, plating is carried out on portions having a high current density so that optimization and uniformity of the plating film thickness and of plating film composition distribution are not obtained.

### Means for Solving the Problem

The present invention is provided in view of the above described problems with the prior art and a plating apparatus of the present invention is a plating apparatus having a plating pre-processing line and a plating line, characterized in that the above described plating line has a plurality of plating baths and a plating liquid containment bath is provided in a desired plating bath from among the above described plating baths.

The plating apparatus of the present invention preferably has a plurality of plating baths underneath the conveyance rail in the plating line. Then, plating liquid containment baths are installed corresponding to these plating baths and are provided with a function of making plating liquid shift between two baths. Alternately, a plurality of plating baths and plating liquid containment baths corresponding to the respective plating baths are installed underneath the conveyance rail and the function of making a plating liquid shift between two baths is provided. Thereby, a plurality of combined plating films of a single layer, or of two or more layers, can be sequentially formed on a conductive material using one conveyance rail.

In addition, the present invention is provided in view of the above described problem with the prior art and a plating method of the present invention is a plating method for forming a plating film by placing an electrode for supplying current and a conductive material on which the plating film is formed within a plating bath containing a desired plating liquid and by applying electricity, characterized in that the current density flowing from the above described electrode is set within the optimal range of current density of the above described plating liquid and the above described conductive material is placed on an auxiliary plating rack and, after that, the plating film is formed on the above described plating material.

According to the plating method of the present invention, preferably the above described conductive material and the above described auxiliary plating rack are integrally utilized as the other electrode of the pair and the above described auxiliary plating rack is positioned between the above described electrode and the above described conductive material so that the thickness of the plating film and the distribution of the composition of the plating film can be adjusted.

In addition, a plating apparatus of the present invention, which is provided in view of the above described problem with the prior art, is a plating apparatus for forming a plating film from a desired plating liquid, an electrode for supplying current and a conductive material placed on an auxiliary plating rack within a plating bath, characterized in that the plating film is formed by installing the above described conductive material within the above described auxiliary plating rack formed of members of a conductive material.

The auxiliary plating rack is preferably a rectangular parallelepiped formed of four main pillars, and the above described conductive material is placed within the above described auxiliary plating rack, and the plating film is formed in the plating apparatus of the present invention. Thereby, uniform current density can be applied to all of the portions of the above described conductive material, even when the surface area, the design, or the like, of the above described conductive material differ.

### Preferred Embodiments of the Invention

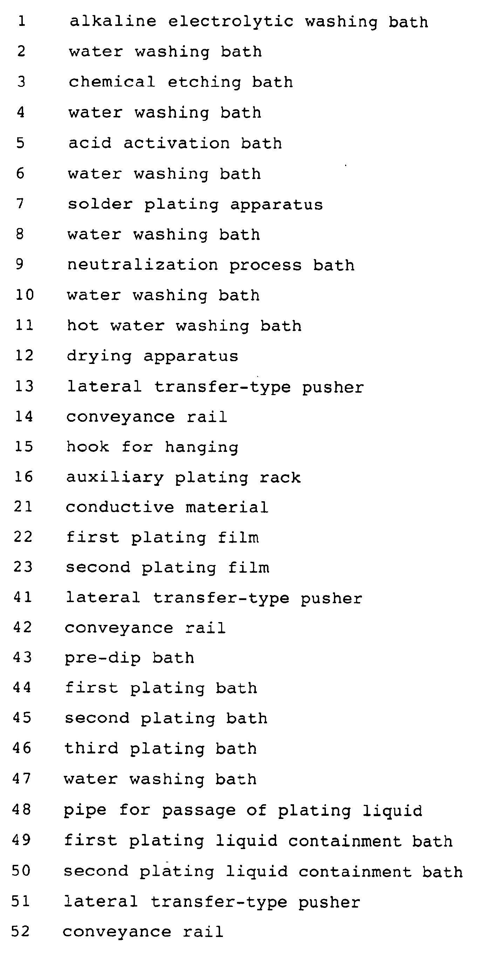

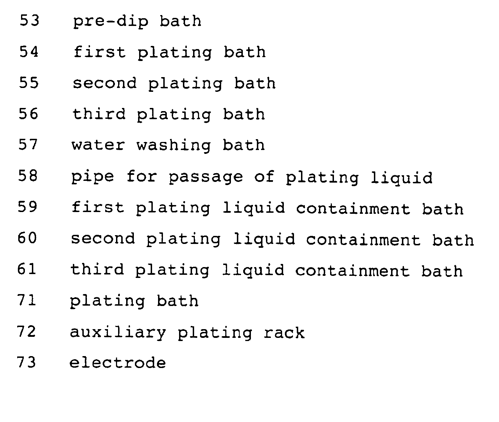

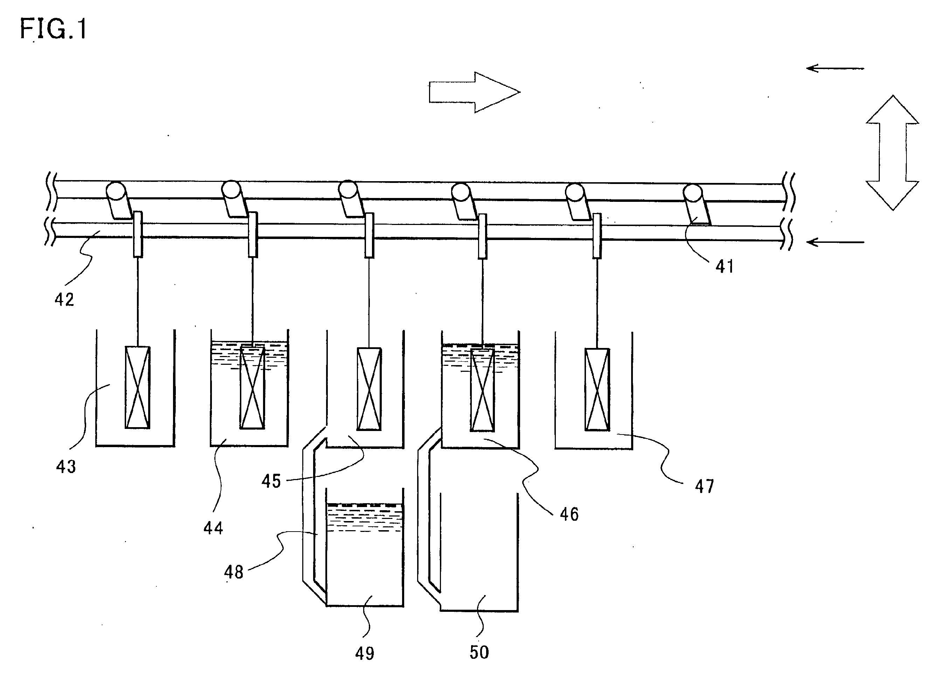

First, a plating apparatus according to the first embodiment, which is a plating apparatus having a plating pre-processing line and a plating line characterized by having plating baths for forming a plating film layer of a plurality of patterns in the plating line and by providing plating liquid containing baths in the respective plating baths is described in reference to Figs. 1, 2 and 7.

Fig. 1 is a layout schematically showing the function of the solder plating line for implementing the plating apparatus of the present invention. A pre-dip bath 43, a first plating bath 44, a second plating bath 45, a third plating bath 46 and a water washing bath 47 are installed underneath a conveyor rail 42 in this solder plating line. Then, conductive materials 21 are transferred in unison by the same pitch by means of lateral transfer-type pushers 41 and plating films are formed on conductive materials 21 using these baths (see Fig. 7) in the same manner as in the prior art.

According to the first embodiment of the present invention, as many plating liquid containment baths as necessary are installed in correspondence with the plating baths. As shown in Fig. 1, for example, a plating liquid containment bath is not installed in first plating bath 44 while first plating liquid containment bath 49 is installed in second plating bath 45 and second plating liquid containment bath 50 is installed in third plating bath 46, respectively. In this case, the plating liquid containment baths are installed underneath the plating baths so that the work space can be efficiently utilized and so that the plating liquids can be contained for a short period of time when the plating liquid is contained. Thereby, this solder plating line is characterized in that a plurality of combined plating films can be sequentially formed on conductive material 21 using one conveyance rail in accordance with the usage application.

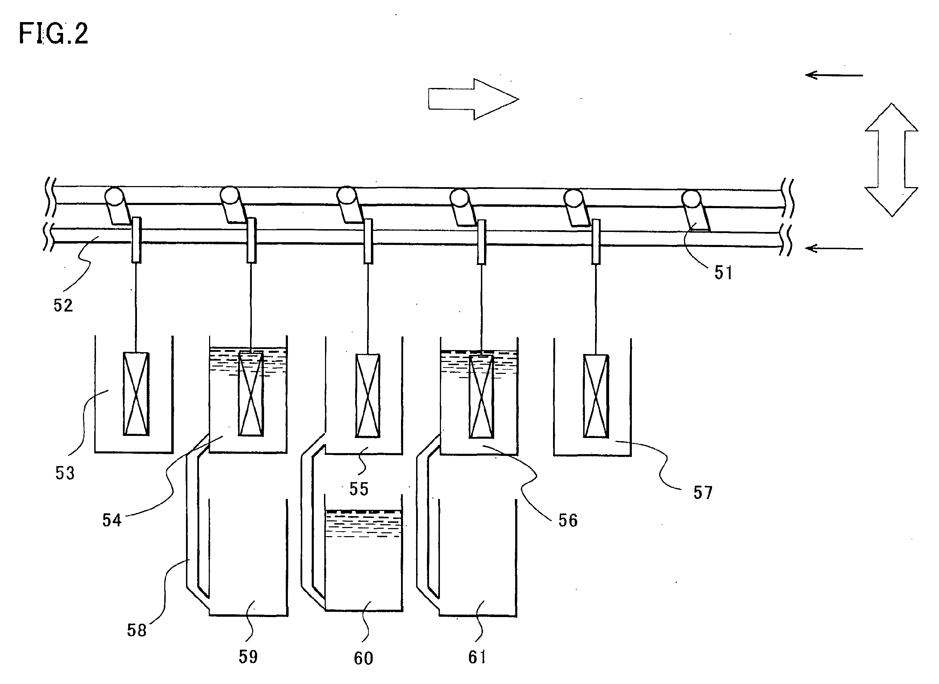

Fig. 2 is also a layout schematically showing the function of a solder plating line for implementing a plating apparatus of the present invention in the same manner as in the above described Fig. 1. A pre-dip bath 53, a first plating bath 54, a second plating bath 55, a third plating bath 56 and a water washing bath 57 are installed underneath a conveyance line 52 in this solder plating line. Then conductive materials 21 are transferred in unison by the same pitch by means of lateral transfer-type pushers 51 and plating films are formed on conductive materials 21 using these baths.

Then, according to the second embodiment plating liquid containment baths are installed for all of the plating baths. As shown in Fig. 2, for example, a first plating liquid containment bath 59 is installed in first plating bath 54, a second plating liquid containment bath 60 is installed in second plating bath 55 and a third plating liquid containment bath 61 is installed in third plating bath 56, respectively. In this case, also, the plating liquid containment baths are installed underneath the plating baths in the same manner as in the above described first embodiment. Thereby, this solder plating line is characterized in that a plurality of combined plating films can be sequentially formed on conductive material 21, which allows plating, using one conveyance rail in accordance with the usage application.

Concretely, with respect to the first embodiment, the conveyance mechanism of this solder plating line is the same as in the above described Fig. 9. In the solder plating line of this Fig. 1, for example, a plating liquid of Sn is contained in first plating bath 44, a plating liquid of Sn-Bi is contained in second plating bath 45 and a plating liquid of Sn-Ag is contained in third plating bath 46. Then, the necessary plating baths from among these plating baths are selected in accordance with the usage applications of conductive material 21 to be plated and the plating liquids in the plating baths that are unused are shifted to plating liquid containment baths. In this embodiment, however, a plating liquid is always contained in first plating bath 44, for containing a plating liquid of Sn, and conductive material 21 is immersed in this plating liquid of Sn. As a result, a single plating film layer of Sn is formed on conductive material 21 or a plating film having a first layer of Sn and a second layer of Sn-Bi or Sn-Ag is formed. Here, the structure of the lead member is the same as Fig. 7 and the same symbols are used.

First, a case is described wherein first plating film 22, which is a single Sn layer, is formed alone on conductive material 21. A plating liquid of Sn is always contained in first plating bath 44, for containing a plating liquid of Sn, and a plating film of Sn is formed on conductive material 21. First, the hydroxide film on the surface is removed in pre-dip bath 43 and, then, conductive material 21 that has been processed in the above described pre-plating process line is immersed in the plating liquid of Sn in first plating bath 44. Then, no plating films are formed on conductive material 21 during this time in second plating bath 45 and third plating bath 46 and, therefore, plating liquids in the baths are shifted to first plating liquid containment bath 49 and second plating liquid containment bath 50. Conductive material 21, on which a plating film of Sn has been formed in first plating bath 44, is conveyed to second plating bath 45 and to third plating bath 46 and those plating baths do not contain any plating liquid and, therefore, no plating films are formed. Next, the surface of conductive material 21, on which a plating film has been formed, is cleaned in water washing bath 47. As a result, a single plating film layer of Sn is formed on conductive material 21.

Second, a case is described wherein two layers, first plating film 22 and second plating film 23, are formed on conductive material 21. The process for forming a plating film on conductive material 21 is the same as described above. First, first plating bath 44 always contains a plating liquid of Sn and, therefore, first plating film 22 of Sn is formed on conductive material 21. Then, the plating bath for forming second plating film 23 is selected in accordance with the usage application of this conductive material 21. Here, in the case that second plating film 23 of Sn-Bi is formed, first, a plating liquid of Sn-Ag in third plating bath 46 is moved to second plating liquid containment bath 50. Next, in the case that a second plating film of Sn-Ag is formed, a plating liquid of Sn-Bi in second plating bath 45 is shifted to first plating liquid containment bath 49 and a plating liquid of Sn-Ag is returned from second plating liquid containment bath 50 to third plating bath 46. As a result, two plating film layers of Sn and of Sn-Bi, or of Sn and of Sn-Ag, are formed on conductive material 21.

Here, in the plating apparatus of Fig. 1, the metal material of the plating liquid in first plating bath 44 is Sn, the metal material of the plating liquid in second plating bath 45 is Sn-Bi and the metal material of the plating liquid in third plating bath 46 is Sn-Ag. In addition, the solutions from which these metals and solvents for solving these metals have been removed have the same liquid constitutions and, therefore, plating films can be sequentially formed on conductive material 21. In some cases, however, plating films are formed on conductive material 21 using plating liquids having different liquid constitutions. At this time, plating baths containing pure water are prepared between plating baths having plating liquids of differing constitutions so that the surface of conductive material 21, which has been plated, is washed and, thereby, these plating liquids having different liquid constitutions are prevented from mixing with each other. In addition, in the case that this pure water is not necessary, the pure water is contained in the plating liquid containment baths. Thereby, a plurality of combined plating films can be sequentially formed on conductive material 21 using one conveyance rail, regardless of the liquid constitutions of the plating liquids.

Concretely, with respect to the second embodiment, the plating method in this solder plating line is the same as in the above described first embodiment. In the solder plating line of the above Fig. 2, a plating liquid of Sn is contained in first plating bath 54, a plating liquid of Sn:Bi = 98 (wt.%): 2 (wt.%) is contained in second plating bath 55 and plating liquid of Sn:Bi = 43 (wt.%): 57 (wt.%) is contained in third plating bath 56. Then, necessary plating baths from among these plating baths are selected in accordance with the usage application of conductive material 21 to be plated and the plating liquids in the plating baths that are unused are shifted to plating liquid containment baths. As a result, a single plating film layer of Sn:Bi = 98 (wt.%): 2 (wt.%) may be formed on conductive material 21, two plating film layers having a first layer of Sn and a second layer of Sn:Bi = 43 (wt.%): 57 (wt.%) may be formed on conductive material 21 or two plating film layers having a first layer of Sn:Bi = 98 (wt.%): 2 (wt.%) and a second layer of Sn:Bi = 43 (wt.%): 57 (wt.%) may be formed on conductive material 21.

In this second embodiment, a plating liquid of Sn:Bi = 98 (wt.%): 2 (wt.%) can be utilized in order to form first plating film 22 on conductive material 21. At this time, approximately several % of Bi may be included in the plating liquid and, thereby, whiskers (crystal in a needle form) can be prevented to a significant extent from being formed on first plating film 22.

Accordingly, the present invention provides plating baths containing a plurality of plating liquids of differing constitutions, and plating liquid containment baths are installed in all of these plating baths, or in the necessary plating baths. Thereby, plating liquids can be shifted between each of these pairs of baths in accordance with the usage application of conductive material 21. As a result, a plurality of combined plating films can be sequentially formed using one conveyance rail.

That is to say, a plurality of combined plating films can be sequentially formed on conductive material 21 using one conveyance rail. Thereby, it becomes unnecessary to temporarily stop the plating apparatus in order to replace the plating liquids in the baths according to the combinations of the plating films. As a result, working time can be greatly shortened, and time and effort necessary to replace the plating liquids can be eliminated. In addition, in the case that one plating liquid is replaced with another in the same bath, the respective plating liquids can be prevented from mixing with each other and, thereby, management of the plating liquids and effort necessary for maintenance of plating baths or other plating equipment can be greatly reduced.

There are other plating methods that allow the sequential formation of a plurality of combined plating films using one conveyance rail. For example, there are methods for forming plating films in the second and third plating baths while shifting the plating liquids in the first plating bath to the first plating liquid containment bath, and for forming a single plating film layer solely in the third plating bath while shifting the plating liquids in the first and second plating baths to the first and second plating liquid containment baths. In addition, a thick plating film can be formed on conductive material 21 by using adjacent plating baths to contain plating liquids of the same composition.

In any case, as described above, it is possible to sequentially form a plurality of combined plating films using one conveyance rail by shifting the plating liquids between each of the pairs of baths according to the present invention.

Though a case of solder plating is described above as an example, this plating apparatus can be utilized without limitation in solder plating. For example, there are Sn plating, Cu plating, Ni plating, and the like. This plating apparatus can be used in these cases so that a plurality of combined plating films can be sequentially formed on conductive material 21 using one conveyance rail.

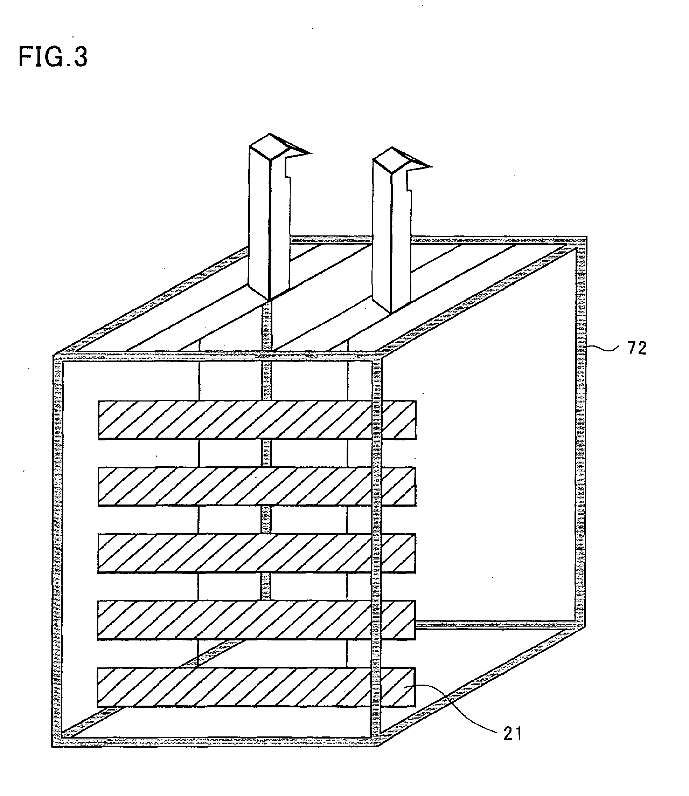

Next, an auxiliary plating rack having a rectangular parallelepiped structure with four main pillars and a plating method wherein this auxiliary plating rack is used are described in reference to Figs. 3, 4 and 7 as the second embodiment.

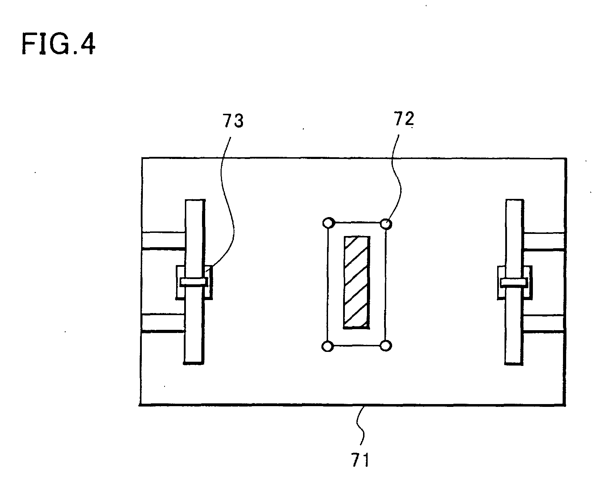

Fig. 3 is a layout schematically showing an auxiliary plating rack used in the implementation of a plating method of the present invention. Then, Fig. 4 is a layout, as viewed from above, of conductive material 21 (see Fig. 7) placed in auxiliary plating rack 72 shown in Fig. 3 being plated in plating bath 71. Here, conductive material 21 is, in most cases, used as a cathode in electrical plating and, therefore, a case is described wherein the electrode is used as anode 73.

The present invention is characterized in that a rectangular parallelepiped auxiliary plating rack 72 formed of four main pillars is used when a plating film is formed on conductive material 21 and, thereby, uniform current density is applied to all portions of conductive material 21, being any of a variety of types of different surface areas, or the like.

Concretely, an appropriate range of current density exists for each plating liquid when plating work is carried out wherein a high quality plating film can be formed by carrying out plating work only within this range. Then, according to this plating method, conductive material 21 is placed in a rectangular parallelepiped auxiliary plating rack 72 formed of four main pillars and is immersed in the plating liquid in plating bath 71 together with this auxiliary plating rack 72. This auxiliary plating rack 72 is formed of conductive members so as to integrally form a cathode with conductive material 21. Then, as shown in Fig. 2, conductive material 21 is placed so as to be positioned at the center of auxiliary plating rack 72 and, therefore, the main pillars of auxiliary plating rack 72 are positioned between anode 73 and conductive material 21.
Thereby, the main portion of the current of high density is directed to the main pillars of auxiliary plating rack 72 while the remaining current density is applied to conductive material 21 so as to form a plating film. As a result, a plating film having a uniform thickness and having a uniform composition distribution can be formed on a variety of conductive materials 21, such as conductive material 21 having a large surface area and conductive material 21 having a small surface area.

There is a case, for example, wherein a plating film is formed on conductive material 21 having a large surface area. Here, an appropriate range of current density exists for the plating liquid. In addition, different levels of current density are applied to the center portion and to the edge portion of conductive material 21 because the surface area thereof is large. In such a case, as described above, the main pillars of auxiliary plating rack 72 are positioned between conductive material 21 and anode 73 and, thereby, electrolysis in the plating liquid is adjusted will assistance in the same manner such that the majority of the high current density can be avoided. As a result, the difference in current density between the portion at the center of conductive material 21 close to anode 73 and the edge portion of conductive material 21 distant from anode 73 becomes small so that a plating film of a uniform film thickness and of a uniform plating composition is formed on the surface of this conductive material 21.

In addition, there is a case wherein a plating film having a first layer of Sn, which is Pb-free plating, and a second layer of Sn-Bi is formed. At this time, a second plating film layer of Sn-Bi is plated to have a range of thickness of approximately 1 µm to 5 µm. Here, when plating is carried out without utilizing auxiliary plating rack 72, dispersion in plating film thickness or a portion wherein the plating film is not formed may occur, particularly at the edge portion and center portion of conductive material 21 when a thin plating film of Sn-Bi is formed, due to the above described electrical plating characteristics. However, by using auxiliary plating rack 72, a plating film of a uniform film thickness and of a uniform plating composition can be formed on the surface of conductive material 21 without the occurrence of a portion wherein the plating film is not formed.

Here, the plating apparatus used according to the plating method of the present invention is described. In this plating apparatus, auxiliary plating rack 72 formed of conductive members is used. This auxiliary plating rack 72 is in a rectangular parallelepiped shape formed of four main pillars. Then, auxiliary plating rack 72 is positioned between conductive material 21 and anode 73 when conductive material 21 is placed at the center and, thereby, assists in the formation of a plating film. At this time, auxiliary plating rack 72 integrally forms a cathode with conductive material 21 and adjusts the electrolysis in the plating liquid so that a plating film of a uniform film thickness and of a uniform plating composition is formed.

Therefore, according to the above described plating method, auxiliary plating rack 72, of a rectangular parallelepiped shape formed of four main pillars made of conductive members, is utilized when a plating film is formed on conductive material 21 in the plating apparatus used therein. Thereby, auxiliary plating rack 72 integrally forms a cathode with conductive material 21 and the four main pillars of auxiliary plating rack 72 are positioned between conductive material 21 and anode 73 and, thereby, the formation of a plating film can be avoided as a result of direct application of a high current density to conductive material 21. As a result, the electrolysis in the plating liquid is adjusted with the assistance of auxiliary plating rack 72 so that a uniform current density is applied to the entirety of the surface of conductive material 21.

That is to say, a plating film is formed on conductive material 21 using auxiliary plating rack 72 and, thereby, the thickness of the plating film and the plating composition distribution are optimized so that a uniform plating film can be formed.

Though a case of solder plating is described above as an example, this plating apparatus can be utilized without limitation to solder plating. There are, for example, Sn plating, Cu plating, Ni plating, and the like. In these cases, a plating film can be formed on a variety of types of conductive materials 21 under conditions suitable for the plating liquid by means of a plating apparatus used according to this plating method.

In addition, though an embodiment of a case wherein electrode 73 is anode 73 is described above, a plating film can be formed on conductive material 21 according to the same plating method in the case wherein electrode 73 is cathode 73.

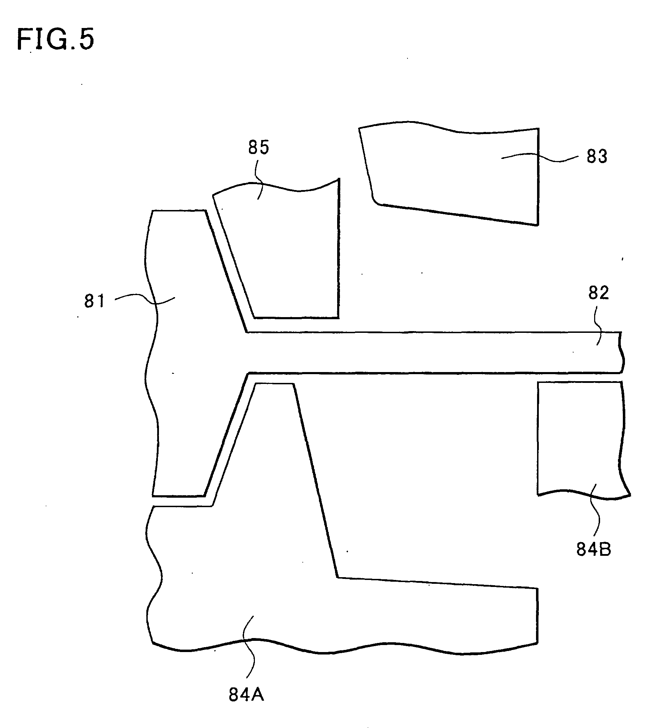

Finally, a plating method for a lead used for a semiconductor device is described in reference to Figs. 5 through 7 as the third embodiment.

First, in a case, in particular, where first plating film 22, such as of a simple Cu, a Cu alloy or an Fe-Ni alloy which is plated on the surface of conductive material 21, is formed using a plating liquid having a main metal material of simple Sn, a smooth film is formed on the surface of first plating film 22. In a case that two types of metals, such as Sn-Bi, are plated as first plating film 22, the first plating film is characterized in that Bi, having a greater ionization tendency, has priority of deposition. As a result phenomenon, the surface of first plating film 22 is formed as a rough film made of deposited grains.

As a result, in a case that the lead frame is contacted during work, the problem described below occurs. During the process of bending, for example, the above described grains forming the rough surface, which have had priority of deposition, come off, and the grains that have come off become attached between leads and, thereby, defects are caused during the process of determining whether or not an IC is a good product by making the electrical terminals make contact with the lead frame. In addition, there is a case wherein the grains that have come off stay on the conveyance means that makes contact with the lead frame in order to reduce the friction between the surfaces when the lead frame is conveyed.

Here, a problem that occurs during the bending process is concretely described. Fig. 5 is a schematic view of a metal mold for bending a lead frame. Then, as illustrated, a lead frame 82 of a semiconductor device 81 is cut or bent by means of a punch 83 when a problem occurs.

First, plated lead frame 82 is placed on supports 84A and 84B, and the mold as well as lead frame 82 of semiconductor device 81 are secured by means of support 84A and a lead support means 85. At this time, the tip of lead frame 82 is placed on support 84B and, then, lead frame 82 is cut by means of punch 83 while the remaining portion is bent. At this time, the bottom of punch 83 and the surface of lead frame 82 make contact with each other wherein a phenomenon occurs such that enlarged deposited grains adhere to the bottom of punch 83 as waste material or adhere to lead frame 82.

In addition, lead frames presently used have approximately 200 pins and the pitch of the pins becomes as narrow as 0.4 mm. Moreover, semiconductor devices, themselves, have become greatly reduced in size and, therefore, it is assumed that the above described attached waste material easily causes defects. Therefore, it is preferable for a semiconductor device to be plated using a plating liquid having a main metal material of simple Sn, or the like, in a manufacturing process as described above.

On the other hand, it is shown that a microscopic amount of Bi is mixed according to the manufacturing method described below in a plating film having a main metal material of simple Sn.

As described in the first embodiment, it is possible to freely select the plating liquid in the plating apparatus of the present invention and it is possible to form first plating film 22 of simple Sn on the surface of conductive material 21. As described in the second embodiment, however, auxiliary plating rack 72 is utilized at the time of plating on conductive material 21 and, therefore, a plating film is formed on the surface of auxiliary plating rack 72. Then, auxiliary plating rack 72 is cleaned in the subsequent step so that the plating film on auxiliary plating rack 72, itself, is removed and auxiliary plating rack 72 is repeatedly utilized in one conveyance line. Therefore, mixing into the plating liquid containing a metal material of simple Sn of a microscopic amount of Bi cannot be avoided. In addition, a microscopic amount of Bi, as an impurity, is mixed into the anode used as electrode 73. Accordingly, a certain amount of Bi relative to Sn is mixed into the plating liquid of simple Sn. There is a possibility that even when first plating film 22 is designed as a plating film made of simple Sn, the semiconductor device is practically formed to have a microscopic amount of Bi in the plating film.

Therefore, the amount of Bi mixed into first plating film 22 that causes a problem is examined. In a case that 0 wt.% to 0.5 wt.% of Bi is included in Sn, no deposition of grains occurs. In addition, in a case that 0.5 wt.% to 1.0 wt.% of Bi is included in Sn, almost no enlargement of deposited grains occurs while a microscopic amount of deposition at a level that does not cause problems may occur. However, in a case that 1.0 wt.% to 3.0 wt.% of Bi is included, a problematic level of enlargement of deposited grains occurs. Then, in a case wherein the enlargement of the deposited grains occurs on the surface of the first plating film, enlargement of the deposited grains on the surface of second plating film 23 naturally occurs.

It is understood from the above description that grain enlargement does not occur when first plating film 22 is formed as a plating film of simple Sn or of Sn having 1 wt.%, or less (particularly 0 wt.% to 0.5 wt.%), of Bi, even in the case of the formation thereon of an Sn-Bi plating film 23 of any concentration.

In the following, a semiconductor device utilizing a lead frame is described wherein a semiconductor chip is mounted on a lead frame and wiring is carried out using fine metal wires. After that, the semiconductor chip is sealed in a mold and the leads that are exposed from the mold are bent. Then, this semiconductor device, which has become a single product, is supplied to the user after electrical measurement via the leads. Then, the user fixes the semiconductor device on the electrodes of a mounting board via a brazing material.

Here, it is possible to carry out a plating process before the semiconductor chip is mounted as well as after the semiconductor chip has been sealed in a mold. In a case that a plating process is carried out before the semiconductor chip is mounted, it is necessary to process the connection portions of the fine metal wires so that no plating film is formed on the connection portions. On the other hand, in a case that a process is carried out after molding, it is possible to immerse metal conductive portions exposed from the mold in plating chemicals and, therefore, there is an advantage wherein selective coating is unnecessary. Here, though a semiconductor chip is described as the circuit device, a passive element or a composite of elements may be sealed in a mold. In addition, as for the molding material, a thermoplastic resin, a thermosetting resin, a ceramic, or the like, can be processed as an object.

In addition, the present invention can be applied to the electrodes of a CSP, or the like, wherein semiconductor chips are secured on electrodes on a support board in a matrix and are separated after molding. In this case, a means for applying electricity to all of the electrodes is necessary.

### Effects of the Invention

As is clear from the above description, the following effects are obtained in the plating apparatus of the present invention.

As for the first effect, this plating apparatus has a function of shifting the plating liquid between the two baths in the solder plating line and, thereby, a single plating film layer or a plurality of combined plating films can be sequentially formed using one conveyance rail. Therefore, it becomes unnecessary to replace the plating liquid with another plating liquid whenever the type of plating film formed on the conductive material is switched, and it is not necessary to temporarily stop the plating apparatus. Thereby, a plurality of combined plating films can be sequentially formed on the conductive material using one conveyance rail and time and effort necessary to replace the plating liquids can be eliminated. In addition, when one plating liquid is replaced with another in the same bath, the respective plating liquids can be prevented from mixing with each other and, thereby, management of the plating liquids and effort necessary for maintenance of plating baths or other plating equipment can be greatly reduced.

As for the second effect, by carrying out plating work according to the plating method of the present invention, the majority of high current density that is otherwise applied to the conductive material, which is of a variety of types having different surface areas, or the like, can be avoided when plating is carried out. Thereby, a uniform current density is applied to the entire surface of the conductive material, which is of a variety of types having different surface areas and designs, while the current density is in an appropriate range for the utilized plating liquid and electrolysis in the plating liquid is also controlled. As a result, the thickness of the plating film and the plating composition distribution can be optimized so that a uniform plating film is formed on a variety of conductive materials.

As for the third effect, a plating film of high quality can be formed on a variety of conductive materials different surface areas, or the like, by utilizing the plating apparatus used according to this plating method, that is to say, by utilizing the auxiliary plating rack in a rectangular parallelepiped shape formed of four main pillars made of conductive members.

As for the fourth effect, according to a manufacturing method for a semiconductor device wherein a plurality of plating film layers is formed on the surface of a conductive material, such as a simple Cu, a Cu alloy or an Fe-Ni alloy, a plating film is formed using a plating liquid having a main metal material of Sn-Bi, in particular, Sn into which a microscopic amount of Bi is mixed, as the first plating film and deposition of grains does not occur on the surface of the first plating film and, even when they occur, they are microscopic deposited grains and, thereby, a manufacturing method for a semiconductor device having an excellent plating film can be implemented.

### Brief Description of the Drawings

Fig. 1 is a diagram for describing a plating line used in a plating apparatus of the present invention;
Fig. 2 is a diagram for describing a plating line used in the plating apparatus of the present invention;
Fig. 3 is a diagram for describing an auxiliary plating rack used in the plating apparatus of the present invention;
Fig. 4 is a layout, as viewed from above, of plating work on a plating bath used in a plating apparatus of the present invention;
Fig. 5 is a diagram for describing a manufacturing method for a semiconductor device of the present invention;
Fig. 6 is a diagram for describing lead frames to which semiconductor chips, which have been plated according to the present invention or according to a prior art, are secured;
Fig. 7 is a diagram for describing a cross section, as viewed in the A-A direction, of a semiconductor lead frame formed of two plating film layers shown in Fig. 6 according to the present invention or according to the prior art;
Fig. 8 is a diagram for describing a layout of the entirety of an automatic plating apparatus according to the present invention or according to the prior art; and
Fig. 9 is a diagram for describing a cross section, as viewed in the B-B direction, of chemical etching baths included in the entirety of the automatic plating apparatus shown in Fig. 7 according to the present invention or according to the prior art.

## Claims

1. A plating apparatus having a plating pre-processing line and a plating line, wherein said plating line has a plurality of plating baths and a desired plating bath from among said plating baths is provided with a plating liquid containment bath.

2. A plating apparatus having a plating pre-processing line and a plating line, wherein said plating line has a plurality of plating baths and desired plating baths from among said plating baths, respectively, are provided with plating liquid containment baths.

3. The plating apparatus according to Claim 1 or 2, wherein a plating film is formed on a conductive material in said plating baths of said plating line.

4. The plating apparatus according to Claim 1 or 2, wherein said plating liquid containment baths are placed at positions lower than said plating baths.

5. The plating apparatus according to Claim 1 or 2, wherein said plating baths are connected to said plating liquid containment baths via pipes so that plating liquids are shifted through the pipes.

6. The plating apparatus according to Claim 1 or 2, wherein a plurality of combined plating films is formed on said conductive material by shifting the plating liquid in each of said plating baths wherein said conductive material is not immersed to the corresponding plating liquid containment bath in said plating line with said conductive material not immersed to the plating liquid.

7. A plating method for forming a plating film by placing an electrode for supplying current and a conductive material on which the plating film is formed within a plating bath containing a desired plating liquid and by applying electricity, wherein the current density flowing from said electrode is set at a value in the optimal range of the current density for said plating liquid and said conductive material is placed in an auxiliary plating rack and, then, a plating film is formed on said conductive material.

8. The plating method according to Claim 7, wherein said conductive material and said auxiliary plating rack are integrally utilized as the other electrode of the pair.

9. The plating method according to Claim 7, wherein said auxiliary plating rack is positioned between said electrode and said conductive material so that the thickness of the plating film and the composition distribution of the plating film are adjusted.

10. A plating apparatus for forming a plating film in a plating bath having a desired plating liquid, an electrode for supplying current and a conductive material placed in an auxiliary plating rack, wherein said conductive material is placed in said auxiliary plating rack formed of conductive members when the plating film is formed.

11. The plating apparatus according to Claim 10, wherein said auxiliary plating rack is in a rectangular parallelepiped shape having four main pillars.

12. A manufacturing method for a semiconductor device, wherein a first plating film layer having a main metal material of Sn is formed on a lead having a main material of Cu or Fe-Ni, wherein a plating film layer having a main metal material of Sn-Bi is formed on the outermost surface of the lead and wherein said lead is secured to a conductive means via a brazing material, wherein said first plating film layer includes approximately 0 wt.% to 1 wt.% of Bi relative to Sn.

13. The manufacturing method for a semiconductor device according to Claim 12, wherein approximately 0 wt.% to 0.5 wt.% of Bi relative to Sn is included.

14. A manufacturing method for a semiconductor device, wherein a lead having a main material of Cu or Fe-Ni is prepared, wherein a circuit device is electrically connected to said lead, wherein the circuit device is sealed in a mold so that a portion of said lead is exposed from the mold, wherein said lead exposed from said mold is bent or the circuit device is electrically measured via said lead and wherein said lead is secured to a conductive means via a brazing material, wherein a first plating film layer having a main metal material of Sn, wherein approximately 0 wt.% to 1 wt.% of Bi relative to the Sn is included, is formed on the surface of said lead and a plating film layer having a main metal material of Sn-Bi is formed on the outermost surface.

15. The manufacturing method for a semiconductor device according to Claim 14, wherein said lead is prepared by carrying out a plating process.

16. The manufacturing method for a semiconductor device according to Claim 14, wherein a plating process is carried out on said lead, which is exposed from said mold, after said lead is sealed in said mold.
